## Europäisches Patentamt

## European Patent Office

## Office européen des brevets

(11) Veröffentlichungsnummer: **0 202 450**
**B1**

(12) **EUROPÄISCHE PATENTSCHRIFT**

(45) Veröffentlichungstag der Patentschrift:
29.06.88

(51) Int. Cl.⁴: **B 64 F 1/34,** H 02 H 5/10

(21) Anmeldenummer: **86104863.5**

(22) Anmeldetag: **09.04.86**

(54) Schaltung für die Bodenstromversorgung des Anschlusssteckers eines Flugzeuges.

(30) Priorität: 23.04.85 DE 3514568
25.02.86 DE 3605937

(43) Veröffentlichungstag der Anmeldung:
26.11.86 Patentblatt 86/48

(45) Bekanntmachung des Hinweises auf die Patenterteilung:
29.06.88 Patentblatt 88/26

(84) Benannte Vertragsstaaten:
CH DE FR GB IT LI NL SE

(56) Entgegenhaltungen:
DE-A-2 111 593
DE-A-2 450 454

British Standard: Aerospace Series, G 219, 1975
Euro Standard DFS 400
Airport Forum, No. 2/1983

Die Akte enthält technische Angaben, die nach
dem Eingang der Anmeldung eingereicht wurden
und die nicht in dieser Patentschrift enthalten sind.

(73) Patentinhaber: Anton Piller GmbH & Co. KG,
Abgunst 24, D-3360 Osterode/Harz (DE)

(72) Erfinder: Sachs, Klaus, Dipl.- Ing., Quellenweg 26,
D-3360 Osterode/Harz (DE)

(74) Vertreter: Gralfs, Harro, Dipl.- Ing., Am
Bürgerpark 8, D-3300 Braunschweig (DE)

## Beschreibung

Die Erfindung bezieht sich auf eine Schaltung nach dem Oberbegriff des Patentanspruches 1.

Bei der bekannten Schaltung für die Bodenstromversorgung des Anschlußsteckers eines Flugzeuges (British Standard: Aerospace Series, G 219 : 1975, Euro-Standard DFS 400) läßt sich das Leistungsrelais bei vom Flugzeug abgezogenem Stecker über den Schließtaster betätigen. Bei einer solchen ungewollten oder leichtfertigen Betätigung stehen für die Dauer der Betätigung des Schließtasters die den Drehstrom führenden Buchsen der Anschlußbuchse unter Spannung. Dies kann zu einer Gefährdung führen.

Es ist bekannt, bei mehrpoligen Kraftsteckvorrichtungen, bei denen die Drehstromphasen über ein in der Steckdose angeordnetes Leistungsschütz geführt sind, in der Steckdose eine im Steuerkreis des Schützes liegende längs- bzw. quergeteilte Kontaktbuchse vorzusehen, die beim Einführen des Steckers in die Steckdose über einen an dem Stecker angeordneten Pilotkontaktstift elektrisch leitend verbunden wird und damit das Leistungsschütz erregt. Beim Ziehen des Steckers fällt in analoger Weise das Schütz ab, sobald der Pilotkontaktstift außer Eingriff mit der Kontaktbuchse kommt. Eine gewillkürte Einschaltung des Leistungsschützes über einen Schließtaster und ein Haltekreis für das Leistungsschütz sind nicht vorgesehen (DE-OS- 24 50 454).

Aufgabe der Erfindung ist es, die Schaltung nach dem Oberbegriff des Patentanspruches 1 so auszugestalten, daß bei abgezogenem Stecker das Leistungsrelais nicht schaltbar ist, und zwar ohne daß vom Bedienungspersonal zusätzliche Maßnahmen getroffen werden müssen.

Diese Aufgabe wird gemäß der Erfindung gelöst durch die im kennzeichnenden Teil des Patentanspruches 1 herausgestellten Schaltungsmaßnahmen

Zweckmäßige Ausgestaltungen sind Gegenstand der Unteransprüche.

Die Erfindung ist in der Zeichnung beispielsweise veranschaulicht und im nachstehenden im einzelnen anhand der Zeichnung beschrieben.

Fig. 1 zeigt eine erste Ausführungsform der Schaltung.

Fig. 2 zeigt eine erweiterte Ausführungsform der Schaltung.

Die in der Schaltung dargestellte Bodenstromversorgung eines Flugzeuges weist bodenseitig einen Drehstromerzeuger 2 auf, dessen Phasen A, B und C über ein elektromagnetisches Leistungsrelais 4 mit einem Spulenkreis 3 schaltbar und zusammen mit dem Nulleiter und Steueradern mit einem flexiblen Kabel 1 auf eine am Ende des Kabels 1 angebrachte Anschlußbuchse 6 mit den Polbuchsen $A_B$, $B_B$, $C_B$, $E_B$, $F_B$ und $N_B$ geführt sind, mit dessen Polbuchse $N_B$ der Nulleiter N des Drehstromerzeugers 2 verbunden ist. In die in der Zeichnung strichpunktiert angedeutete Bordwand 8, des Flugzeuges ist ein Anschlußstecker 10 mit den Polsteckerstiften $A_S$, $B_S$, $C_S$, $E_S$, $F_S$ und $N_S$ eingelassen, auf den die Anschlußbuchse 6 aufsteckbar ist.

Für die Stromversorgung des Spulenkreises 3 des Leistungsrelais 4 ist bordseitig eine Stromquelle 12 vorgesehen, die im Beispielsfall eine 28 V Gleichstromquelle ist, welche mit ihrem Minuspol mit dem Nulleiter N der Drehstromquelle 2 verbunden ist. Mit dem Nulleiter N ist weiter ein Anschluß 14' einer Spule 14 des ersten Relais 4 verbunden, deren anderer Anschluß 14'' über einen Schließtaster 16 und gegebenenfalls einen Unterbrechertaster 11 an den Pluspol der Stromquelle 12 angeschlosen ist.

Das Leistungsrelais 4 weist neben seinen Leistungsschließkontakten 13 einen Halteschließkontakt 18 auf, dessen einer Pol 18' zwischen dem Schließtaster 16 und dem Minuspol der Stromquelle 12 mit dem Spulenkreis 3 des Leistungsrelais 4 verbunden ist. Der zweite Pol 18'' des Halteschließkontaktes 18 ist über eine Sperrdiode 21 und einen Unterbrechertaster 20 mit der Polbuchse $F_B$ der Anschlußbuchse 6 verbunden.

An Bord des Flugzeuges befindet sich ein Drehstromtransformator 22, von dessen Sekundärseite ein Gleichrichter 24 gespeist wird, der bordseitig eine 28 V Gleichstromquelle bildet. Der eine Pol, vorzugsweise der Pluspol dieser Gleichstromquelle, ist über einen bordseitigen Unterbrechertaster 26 an den Polsteckerstift $F_S$ des Anschlußsteckers 10 geführt, während der andere Pol an den Nulleiter N des bordseitigen Drehstromnetzes mit den Phasen A, B, C geschaltet ist.

Nach dem Aufstecken der Anschlußbuchse 6 auf dem bordseitigen Anschlußstecker 10 wird für die Spule 14 des Leistungsrelais 4 ein Haltekreis 23 gebildet, der von der vom Gleichrichter 24 gebildeten Gleichstromquelle gespeist wird. Auf diese Weise wird sichergestellt, daß das Leistungsrelais 4 nur dann geschaltet ist, wenn zwischen allen drei bordseitigen Phasen A, B und C der Drehstromversorgung die über das Kabel 1 gelieferte Spannung vorhanden ist.

Die vorstehend beschriebene Schaltung ist bekannter Art. Sie hat den Nachteil, daß bei abgezogener Anschlußbuchse 6 bei beabsichtigter oder unbeabsichtigter Betätigung des Schließtasters 16 das Leistungsrelais 4 eingeschaltet wird, wobei dann an den Buchsen A, B und C der Anschlußbuchse 6 die Spannung der Drehstromquelle 2 anliegt.

Dies wird erfindungsgemäß verhindert durch ein zweites elektromagnetisches Relais 28 mit einem Schließkontakt 30 und einer Spule 29. Bei Erregung der Spule 29 wird der im Spulenkreis 3 der Spule 14 des ersten Leistungsrelais 4 liegende Schließkontakt geschlossen. Die Spule 29 liegt im Stromkreis einer Niederspannungsquelle die vorzugsweise ein Wechselstromtransformator 32 mit einer Ausgangsspannung von beispielsweise 6 V ist. Der Transformator 32 ist sekundärseitig mit einem Pol 33' über die Spule 29 des zweiten Relais 28 und den bodenseitigen Unterbrechertaster 20 unter teilweiser Verwendung der Leitung des Haltekreises 23 auf die Polbuchse $F_B$ geführt, in/an der Schaltmittel angeordnet sind, die über den zugehörigen Polsteckerstift $F_S$ geschlossen werden können.

Bei der dargestellten Ausführungsform ist·die Polbuchse $F_B$ in Längsrichtung geteilt, so daß zwei elektrisch getrennte Kontaktelemente $F_B'$ und $F_B''$ gebildet werden Auch eine Querteilung ist möglich. Der Pol 33 des Transformators 32 ist an das Kontaktelement $F_B''$ angeschlossen. Das Kontaktelement $F_B'$ ist mit der zum Pol 18'' des Haltekontaktes 18 des ersten Leistungsrelais 4 führenden Leitung 23 verbunden, an die zwischen dem Unterbrechertaster 20 und dem Pol 18'' auch die Spule 29 des zweiten Relais 28 angeschlossen ist. Der gebildete Spulenkreis 31 des zweiten Relais 28 wird durch den Polsteckerstift $F_S$ des Anschlußsteckers 10 geschlossen, der die beiden Kontaktelemente $F_B'$ und $F_B''$ der Polbuchse $F_B$ kontaktiert und damit die elektrische Verbindung zwischen ihnen herstellt. Wenn die· Anschlußbuchse 6 auf den Anschlußstecker 10 aufgesteckt ist, zieht damit das zweite Relais 28 an und schließt den Schließkontakt 30 im Spulenkreis 3. Über den Schließtaster 16 ist damit das Leistungsrelais 4 einschaltbar.

Wird die Anschlußbuchse 6 von dem Anschlußstecker 10 abgezogen, wird der Spulenkreis 31 des zweiten Relais 28 geöffnet. Das zweite Relais 28 fällt ab und öffnet den Schließkontakt 30 im Spulenkreis 3 des ersten Leistungsrelais 4. Damit kann über den Schließtaster 16 das Leistungsrelais 4 nicht mehr betätigt werden. Es können damit die Anschlußbuchsen $A_B$, $B_B$ und $C_B$ weder beabsichtigt noch unbeabsichtigt unter Spannung geraten.

Die vorstehend beschriebene Schaltung arbeitet automatisch, d.h. es können keine Eingriffe von Hand durchgeführt werden, die die Wirkung dieser Sicherung gegen ungewolltes oder unbefugtes Betätigen des Leistungsrelais 4 unwirksam machen. In dem Anschlußkabel 1 zwischen dem Relais 4 und der Anschlußbuchse 6 wird lediglich eine zusätzliche Leitung zum Kontaktelement $F_B''$ in der Anschlußbuchse 6 benötigt, die normalerweise in den hier verwendeten Anschlußkabeln zur Verfügung steht.

Die Ausführung mit der geteilten Polbuchse $F_B$ ist leicht zu realisieren und im Betrieb unempfindlich, und zwar auch gegen Verschmutzung sowie Eisbildung. Es können aber auch andere Schaltmöglichkeiten vorgesehen werden. So kann beispielsweise in der Wandung der Polbuchse $F_B$ eine Ausnehmung vorgesehen sein, in der isoliert gegen die Polbuchse $F_B$ eine gesonderte Kontaktfläche vorgesehen ist, die als zweites Kontaktelement im Spulenkreis 31 der Spule 29 eschaltet ist. Auch hierbei wird die Verbindung direkt über den Polsteckerstift $F_S$ bewirkt. Es besteht aber auch die Möglichkeit, über den Polsteckerstift $F_S$ oder einen anderen Steckerstift einen gesonderten Schalter in/an der Anschlußbuchse 6 zu betätigen, wobei das Betätigungselement für den Schalter dann aus einem Isolierwerkstoff besteht. Die Betätigungskraft kann dabei durch den Polsteckerstift $F_S$ beispielsweise radial oder axial aufgebracht werden. Mit diesem Schalter wären dann einerseits die Spule 29 des zweiten Relais 28 und andererseits der Pol 33 des Transformators 32 zu verbinden.

Die bekannte Schaltung für die Anschlußbuchse der Bodenstromversorgung eines Flugzeuges, bei der der Haltekreis des Leistungsrelais von der Gleichstromquelle an Bord des Flugzeuges mit Strom versorgt wird, hat den Nachteil, daß die Spule des Leistungsrelais eine für die Auslegungsleistung dieser Gleichstromquelle beträchtlichen Strombedarf hat. Wenn für die Niederspannungsstromquelle für den Spulenkreis eines weiteren elektromagnetischen Relais ein Wechselstromtransformator als billigste Art der Stromquelle verwendet wird, besteht darüber hinaus die Gefahr, daß bei einem Durchschlagen des Transformators dessen primärseitiges Wechselspannungspotential über die Steckerverbindung ins Flugzeug gelangt.

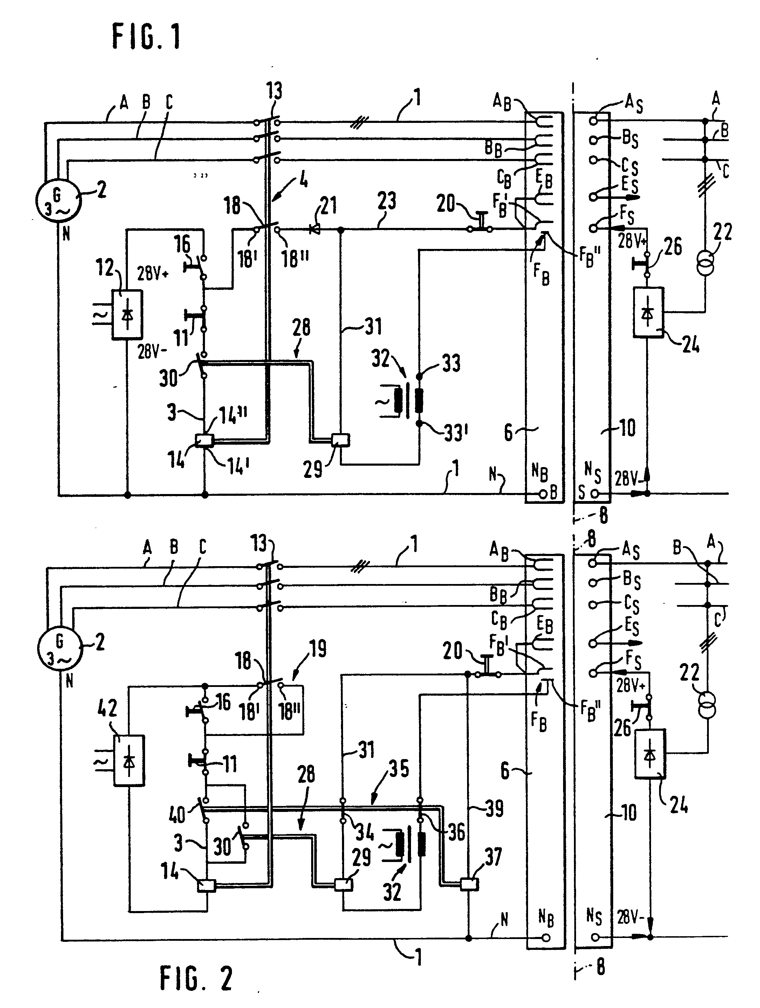

Beide Nachteile werden vermieden bei einer Schaltung, wie sie in Fig. 2 dargestellt ist. In dieser Zeichnung sind gleiche Bauelemente mit gleichen Bezugszeichen wie in Fig. 1 versehen. Soweit die Schaltung mit der nach Fig. 1 übereinstimmt, wird auf die vorstehende Beschreibung verwiesen.

Für das Leistungsrelais 4 mit der Spule 14 einschließlich des Haltekreises dieses Relais 4 ist hier eine von der durch den Gleichrichter 24 gebildeten Gleichstromquelle an Bord des Flugzeuges unabhängige Stromversorgung 42 vorgesehen. Wegen der Unabhängigkeit dieser Stromquelle 42 ist auch deren Ausgangsspannung unabhängig von der 28 V betragenden Spannung durch den Gleichrichter 24 gebildeten Gleichstromquelle an Bord des Flugzeuges. Es kann als Ausgangsspannung also auch eine höhere Spannung vorgesehen und die Spule 14 des ersten Leistungsrelais 4 dafür ausgelegt werden.

Darüber hinaus steht es frei, Wechselspannung oder Gleichspannung zu verwenden. Bei dem Ausführungsbeispiel ist die Ausgangsspannung eine Gleichspannung, es könnte auch direkt eine vorhandene Netzspannung als Wechselspannung verwendet werden. Es kann aber auch die übliche 28 V Gleichstromquelle vorgesehen werden.

Der mit dem Halteschließkontakt 18 des ersten Leistungsrelais 4 gebildete Haltekreis 19 ist hier in üblicher Weise parallel zu dem Schließtaster 16 im Spulenkreis 3 des Relais 4 geschaltet, in dem weiter, wie bei der Schaltung nach Fig. 1, ein Schließkontakt 30 des zweiten Relais 28 liegt. Der Spulenkreis 31 des zweiten Relais mit der Spule 29 und der Niederspannungsstromqelle 32, der hier ohne Verbindung zum Haltekreis 3 des ersten Relais 4 ist, ist wie bei der Ausführungsform nach Fig. 1 überSchaltmittel wie z. B. Kontaktelemente an der Polbuchse F der Anschlußbuchse 6 geführt und über den Polsteckerstift $F_S$ des Anschlußsteckers 10 am Flugzeug schließbar. Weder für den Spulenkreis 3 noch für den Spulenkreis 31 ist eine Verbindung zum Nulleiter der Drehstromquelle 2 erforderlich.

Zusätzlich ist bei der Ausführungsform nach Fig. 2 ein drittes Relais 35 vorgesehen, dessen Spule 37 in einer Verbindung 39 zwischen dem Nulleiter N und dem Teil des Spulenkreises 31 des zweiten Relais 28 liegt, in dem der bodenseitige Unterbrechertaster 20 angeordnet ist. Die Spule 37 liegt damit in einem Stromkreis der über die Steckerverbindungen mit Nulleiter N und Polbuchse F und die durch den Gleichrichter 24 gebildeten Gleichstromquelle an Bord des Flugzeuges geführt ist, die bei geschlossener Steckerverbindung mit Anschlußbuchse 6, und Anschlußstecker 10 die Spule 37 des dritten Relais 35 mit Strom versorgt.

Das dritte Relais 35 weist drei Schaltkontakte auf. Davon liegen zwei als Unterbrecherkontakte 34, 36 ausgebildete Schaltkontakte im Spulenstromkreis 31 des zweiten Relais 28, und zwar hier beidseits der Sekundärspule des Transformators 32. Ein dritter als Schließkontakt ausgebildeter Schaltkontakt 40 liegt parallel zu dem Schließkontakt 30 des zweiten Relais im Spulenkreis 3 des ersten Leistungsrelais 4.

Beim Herstellen der Steckerverbindung mit dem Flugzeug wird der Spulenstromkreis 31 des zweiten Relais 28 durch den Polsteckerstift $F_S$ geschlossen. Damit schließt der Schließkontakt 30. Es kann dann über den Schließtaster 16 der Spulenkreis 3 geschlossen und das erste Leistungsrelais 4 eingeschaltet werden. Die durch den Gleichrichter 9 gebildeten Glechstromquelle 24 an Bord des Flugzeuges liefert dann Strom, der durch die Spule 37 des dritten Relais 35 fließt. Beim Anziehen des dritten Relais 35 werden dessen Unterbrecherkontakte 34 und 36 geöffnet und gleichzeitig bzw. kurz davor der Schließkontakt 40 geschlossen. Durch das Öffnen der Unterbrecherkontakte 34 und 36 werden die Anschlüsse der Sekundärseite der durch den Transformator 36 gebildeten Niedervoltspannungsquelle beidseitig getrennt, so daß deren elektrische Verbindung zum Flugzeug unterbrochen wird. Damit wird die Spule 29 des zweiten Relais 28 stromlos und dieses Relais fällt ab, wobei der Schließkontakt 30 öffnet. Da der hierzu parallele Schließkontakt 40 des dritten Relais 35 geschlossen ist, bleibt das Leistungsrelais eingeschaltet. Die korrekte Schaltfolge, nämlich Schließen des Schließkontaktes 40 bevor der Schließkontakt 30 im Spulenkreis 3 des Leistungsrelais öffnet, wird durch die üblicherweise vorhandenen Trägheiten der Relais sichergestellt. Sofern erforderlich, kann für das zweiten Relais 28 eine leichte Schaltverzögerung vorgesehen werden.

Bei der beschriebenen Schaltung nach Fig. 2 braucht von der bordseitigen Gleichstromquelle 24 Spulenstrom des dritten Relais 35 geliefert werden. Dieses Relais 35 hat als Hilfsrelais einen erheblich geringeren Leistungsbedarf für seine Spule 37 verglichen mit dem Leistungsbedarf für die Spule 14 des ersten Leistungsrelais 4. Bei der genannten Schaltung wird also die Gleichstromquelle 24 an Bord des Flugzeuges wesentlich weniger belastet als bei der Schaltung nach Fig. 1.

Die Schaltung nach Fig. 2 hat darüber hinaus den Vorteil, daß sie ohne jegliche Änderung auch für Flugzeuge verwendet werden kann, bei denen an Bord keine Gleichstromquelle 24 vorgesehen ist, wie es beispielsweise bei Flugzeugen aus sowjetischer Produktion der Fall ist. Wenn keine Gleichstromquelle 24 vorgesehen ist, bleibt nach Herstellen der Steckerverbindung mit dem Flugzeug das dritte Relais 35 stromlos. Es wird lediglich über Polsteckerstift F des bordseitigen Steckers der Spulenstromkreis 31 des zweiten Relais 28 geschlossen. Die Gefahr einer Potentialverschleppung bei einem Durchschlag des Transformators 32 besteht hier nicht, da der Polsteckerstift F bordseitig keine Verbindung zum Bordnetz hat.

Im vorstehenden sind diejenigen Kontakte der Relais, die bei Erregung der Spule schließen, als Schließkontakt und diejenigen Kontakte, die dabei öffnen, als Unterbrecherkontakte bezeichnet. Entsprechend sind die Bezeichnungen für die Taster gewählt

## Patentansprüche

1. Schaltung für die Bodenstromversorgung des Anschlußsteckers (10) eines Flugzeuges über ein mit einer Anschlußbuchse (6) versehenes bodenseitiges Kabel mit einem elektromagnetischen ersten Leistungsrelais (4) für die drei Phasen der Drehstromversorgung, das von einer bodenseitigen Stromquelle über einen Schließtaster (16) etätigbar und mit einem Selbsthaltekreis (23) versehen ist, der über eine von der Drehstromversorgung unabhängige Steckerverbindung (FB) eine an deren Polsteckerstift ($F_S$) am flugzeugseitigen Anschlußstecker (10) anliegende Gleichstromquelle (24) an Bord des Flugzeuges einschließt, dadurch gekennzeichnet, daß im Spulenkrels (3) des elektromagnetischen ersten Leistungsrelais (4) bodenseitig ein Schließkontakt (30) eines zweiten elektromagnetischen Relais (28) vorgesehen ist, dessen Spulenkreis (31) im Stromkreis einer Niederspannungsstromquelle (32) liegt, und über Schaltmittel (Kontaktelemente $F_B'$-$F_B''$) in der Anschlußbuchse (6) geführt ist, welcher Stromkreis über den von der Drehstromversorgung unabhängigen Polsteckerstift ($F_S$) des flugzeugseitigen Anschlußsteckers (10) schließbar ist, so daß bei

4

abgezogener Anschlußbuchse (6) das zweite Relais (28) abfällt und so den Spulenkreis (31) des ersten Relais (4) öffnet.

2. Schaltung nach Anspruch 1, dadurch gekennzeichnet, daß ein drittes elektromagnetisches Relais (35) vorgesehen ist, dessen Spulenkreis (39) über die Anschlußbuchse (6) mit der bordseitigen Gleichstromquelle (24) verbunden ist und das einen parallel zum Schließkontakt (30) des zweiten Relais (28) im Spulenkreis (3) des ersten Leistungsrelais (4) liegenden Schließkontakt (40) sowie weitere Schaltelemente (34, 36) aufweist, welche bei Erregung des dritten Relais (35) die Niederspannungsstromquelle (32) aus dem Spulenkreis (31) des zweiten Relais (28) trennen.

3. Schaltung nach Anspruch 2, dadurch gekennzeichnet, daß das dritte Relais (35) als weitere Schaltelemente zwei Öffnungskontakte (34, 36) aufweist, die beidseitig der Niederspannungsstromquelle (32) im Spulenkreis (31) des zweiten Relais (28) liegen.

4. Schaltung nach Anspruch 2, dadurch gekennzeichnet, daß das dritte Relais (35) als weitere Schaltelemente zwei Öffnungskontakte aufweist, die beidseitig der Primärspule eines als Niederspannungsstromquelle dienenden Transformators angeordnet sind.

5. Schaltung nach Anspruch 1, dadurch gekennzeichnet, daß die mit dem unabhängigen Steckerstift ($F_S$) zusammenwirkende Polbuchse ($F_B$) in der Anschlußbuchse (6) zwei gegeneinander isolierte Kontaktelemente ($F_B'$, $F_B''$) aufweist, die durch den Polsteckerstift ($F_S$) elektrisch leitend verbindbar sind und die im Stromkreis der gesonderten Niederspannungsquelle (32) liegen.

6. Schaltung nach Anspruch 5, dadurch gekennzeichnet, daß die Polbuchse ($F_B$) in Längsrichtung in zwei gegeneinander isolierte Polbuchsenteile (Kontaktelemente $F_B'$, $F_B''$) geteilt ist.

7. Schaltung nach Anspruch 5 oder 6, dadurch gekennzeichnet, daß über die Polbuchse ($F_B$) mit den zwei Kontaktelementen ($F_B'$, $F_B''$) der Haltekreis des Leistungsrelais (4) in der Anschlußbuchse (6) geführt ist.

8. Schaltung nach Anspruch 1, dadurch gekennzeichnet, daß in/an der Anschlußbuchse (6) ein durch einen der Polsteckerstifte ($F_S$) des Anschlußsteckers (10) betätigbarer gesonderter Schalter im Spulenkreis des zweiten elektromagnetischen Relais (28) angeordnet ist.

## Claims

1. Circuit for the ground power supply of an aircraft connection plug (10) via a ground cable, provided with a connecting socket (6), with an electromagnetic first power relay (4) for the three phases of the three-phase supply which can be operated via a normally-open key switch (16) from a ground power source and is provided with a self-holding circuit (23) which includes, via a plug connection ($F_B$), which is independent of the three-phase supply, a direct-current source (24) on board the aircraft which is present at the pole plug pin ($F_S$) of this plug connection ($F_B$) at the aircraft-side connecting plug (10), characterized in that in the coil circuit (3) of the electromagnetic first power relay (4) on the ground a normally-open contact (30) of a second electromagnetic relay (28) is provided, the coil circuit (31) of which is located in the circuit of a low voltage power source (32) and is conducted via switching means (contact elements $F_B'$-$F_B''$) in the connecting socket (6), which circuit can be closed via the pole plug pin ($F_S$) which is independent of the three-phase supply, of the aircraft-side connecting plug (10) so that the second relay (28) drops out and thus opens the coil circuit (31) of the first relay (4) when the connecting socket (6) is pulled out.

2. Circuit according to Claim 1, characterized in that a third electromagnetic relay (35) is provided, the coil circuit (39) of which is connected via the connecting socket (6) to the on-board direct-current source (24) and which exhibits a normally-open contact (40), which is located in parallel with the normally-open contact (30) of the second relay (28) in the coil circuit (3) of the first power relay (4) and other switching elements (34, 36) which separate the low voltage current source (32) from the coil circuit (31) of the second relay (28) when the third relay (35) is excited.

3. Circuit according to Claim 2, characterized in that the third relay (34) exhibits as further switching elements two normally-closed contacts (34, 36) which are located on both sides of the low voltage power source (32) in the coil circuit (31) of the second relay (28).

4. Circuit according to Claim 2, characterized in that the third relay (35) exhibits, as further switching elements, two normally-closed contacts which are arranged on both sides of the primary coil of a transformer used as low-voltage power source.

5. Circuit according to Claim 1, characterized in that the pole socket ($F_B$) operating In conjunction with the independent plug pin ($F_S$) in the connecting socket (6) exhibits two mutually insulated contact elements ($F_B'$, $F_B''$) which can be electrically conductively connected by the pole plug pin ($F_S$) and which are located in the circuit of the separate low-voltage source (32).

6. Circuit according to Claim 5, characterized in that the pole socket ($F_B$) is divided into two mutually insulated pole socket parts (contact elements $F_B'$, $F_B''$) in the longitudinal direction.

7. Circuit according to Claim 5 or 6, characterized in that the holding circuit of the power relay (4) is connected in the connecting socket (6) via the pole socket ($F_B$) having the two contact elements ($F_B'$, $F_B''$).

8. Circuit according Claim 1, characterized in that a separate switch, which can be operated by one of the pole plug pins ($F_S$) of the connecting

plug (10) is arranged in the coil circuit of the second electromagnetic relay (28) in/at the connecting socket (6).

## Revendications

1. Circuit pour l'alimentation en courant au sol d'une fiche de connexion (10) d'un avion par l'intermédiaire d'un câble côté sol muni d'une douille de connexion (6), comportant un premier relais électromagnétique de puissance (4) pour les trois phases de l'alimentation en courant triphasé, qui est actionnable par une source de courant au sol par l'intermédiaire d'une touche de fermeture (16) et est muni d'un circuit d'auto-maintien (23), qui comprend, par l'intermédiaire d'une liaison par fiche $(F_B)$ indépendante de l'alimentation en courant triphasé, une source de courant continu (24) à bord de l'avion reliée à la fiche polaire $(F_S)$ de la fiche de connexion (10) à bord de l'avion, caractérisé en ce que, dans le circuit de bobine (3) du premier relais électromagnétique de puissance (4) au sol, est prévu un contact de fermeture (30) d'un second relais électromagnétique (28), dont le circuit de bobine (31) se trouve dans le circuit d'une source de courant basse tension (32), et est amené par l'intermédiaire de moyens de commutation (éléments de contact $F_B'$-$F_B''$) dans la douille de connexion (6), circuit qui peut être fermé par l'intermédiaire de la fiche polaire $(F_S)$ indépendante de l'alimentation en courant triphasé de la fiche de connexion (10) de l'avion, de sorte que, lors du retrait de la douille de connexion (6), le second relais (28) retombe et ainsi le circuit de bobine (31) du premier relais (4) s'ouvre.

2. Circuit selon la revendication 1, caractérisé en ce qu'un troisième relais électromagnétique (35) est prévu, dont le circuit de bobine (39) est relié, par l'intermédiaire de la douille de connexion (6), à la source de courant continu (24) du bord et qui comporte un contact de fermeture (40) se trouvant en parallèle sur le contact de fermeture (30) du second relais (28) dans le circuit de bobine (3) du premier relais de puissance (4), ainsi que d'autres éléments de commutation (34, 36), qui, lors de l'excitation du troisième relais (35), coupent la source de courant basse tension (32) du circuit de bobine (31) du second relais (28).

3. Circuit selon la revendication 2, caractérisé en ce que le troisième relais (35) comporte en tant qu'autres éléments de commutation deux contacts d'ouverture (34, 36) qui se trouvent sur les deux côtés de la source de courant basse tension (32) dans le circuit de bobine (31) du second relais (28).

4. Circuit selon la revendication 2, caractérisé en ce que le troisième relais (35) comporte en tant qu'autres éléments de commutation deux contacts d'ouverture, qui sont disposés sur les deux côtés de l'enroulement primaire d'un transformateur servant de source de courant basse tension.

5. Circuit selon la revendication 1, caractérisé en ce que la douille polaire $(F_B)$ coopérant avec la fiche $(F_S)$ indépendante dans la douille de connexion (6) comporte deux éléments de contact isolés l'un de l'autre $(F_B', F_B'')$, qui peuvent être réunis de façon électriquement conductrice par la fiche polaire $(F_S)$ et se trouvent dans le circuit de la source basse tension particulière (32).

6. Circuit selon la revendication 5, caractérisé en ce que la douille polaire $(F_B)$ est partagée dans le sens longitudinal en deux parties de douille polaire isolées l'une de l'autre (éléments de contact $F_B', F_B''$).

7. Circuit selon la revendication 5 ou 6, caractérisé en ce que le circuit de maintien du relais de puissance (4) est amené par l'intermédiaire de la douille polaire $(F_B)$ aux deux éléments de contact $(F_B', F_B'')$ dans la douille de connexion (6).

8. Circuit selon la revendication 1, caractérisé en ce que dans/sur la douille de connexion (6) est disposé un interrupteur spécial actionnable par une des fiches polaires $(F_S)$ de la fiche de connexion (10) dans le circuit de bobine du second relais électromagnétique (28).

# FIG.1

# FIG. 2